# EUROPÄISCHE PATENTANMELDUNG

(11) **EP 2 244 539 A2**
(43) Veröffentlichungstag der Anmeldung: **27.10.2010**
(21) Anmeldenummer: 10160441.1
(22) Anmeldetag: 20.04.2010
(51) Int. Cl.: H05K 1/18, H05K 1/14

(54) **Flachbaugruppe und Verfahren zu deren Herstellung**

(30) Priorität: 22.04.2009 DE 102009018184
(71) Anmelder: Gigaset Communications GmbH, 81379 München (DE)
(72) Erfinder: Holla, Wolfgang, 47608, Geldern (DE); Wissing, Jörg, 46397, Bocholt (DE); Terglane, Hermann-Josef, 48619, Heek (DE)
(74) Vertreter: Michalski Hüttermann & Partner Patentanwälte

(57) **Zusammenfassung**

Die Erfindung betrifft eine Flachbaugruppe, welche folgende Elemente enthält: eine Platine (20) aus einem dielektrischen Material, auf welchem Leiterbahnen und erste Anschlusskontakte (21) angeordnet sind, zumindest ein Bauelement (30) mit einer Mehrzahl von zweiten Anschlusskontakten (31) und ein Verbindungselement (10) aus einem flexiblen Material, welches die ersten Anschlusskontakte mit den zweiten Anschlusskontakten verbindet, wobei das Verbindungselement zumindest einen ersten Längsabschnitt (11) aufweist, in welchem Leiterbahnen und Anschlusskontakte in genau einer Ebene angeordnet sind und zumindest einen zweiten Längsabschnitt (12), in welchem Leiterbahnen und Anschlusskontakte in zumindest zwei Ebenen angeordnet sind. Weiterhin betrifft die Erfindung ein Verfahren zur elektrischen Kontaktierung eines Bauelementes mit zweiten Anschlusskontakten auf einer Flachbaugruppe mit ersten Anschlusskontakten mit einem Verbindungselement aus einem flexiblen Material, welches zumindest einen ersten Längsabschnitt aufweist, in welchem Leiterbahnen und/oder Anschlusskontakte in genau einer Ebene angeordnet sind, und zumindest einen zweiten Längsabschnitt, in welchem Leiterbahnen und/oder Anschlusskontakte in zumindest zwei Ebenen angeordnet sind.

## Beschreibung

Die Erfindung betrifft eine Flachbaugruppe, welche folgende Elemente enthält: eine Platine aus einem dielektrischen Material, auf welchem Leiterbahnen und erste Anschlusskontakte angeordnet sind, zumindest ein Bauelement mit einer Mehrzahl von zweiten Anschlusskontakten und ein Verbindungselement aus einem flexiblen Material, welches die ersten Anschlusskontakte mit den zweiten Anschlusskontakten verbindet.

Flachbaugruppen der eingangs genannten Art werden in elektronischen Geräten aller Art eingesetzt, um eine Vielzahl elektronischer Bauelemente mechanisch zu fixieren und elektrisch miteinander zu verbinden.

Aus dem Stand der Technik ist bekannt, Bauelemente, wie beispielsweise Flüssigkristall-Displays, mittels eines Verbindungselementes auf der Platine einer Flachbaugruppe zu kontaktieren. Als Verbindungselement eignet sich insbesondere ein Kabel oder eine gedruckte Leiterplatte aus einem flexiblen Material, wie beispielsweise Polyimid. Durch Strukturieren einer auf dem Trägermaterial festhaftend angebrachten Kupferschicht können an beiden Enden des Verbindungselements Kontaktelemente zur Kontaktierung des Bauelementes und der Platine sowie zwischen den Kontaktelementen liegende elektrische Leiterbahnen ausgebildet werden. Dabei kann die geometrische Anordnung der Kontaktelemente in gewissen Grenzen angepasst werden, so dass verschiedene Bauelemente, beispielsweise unterschiedliche Displays unterschiedlicher Technologie, mittels jeweils angepasster Verbindungselemente auf derselben Platine kontaktiert werden können. Auf diese Weise kann beispielsweise eine Geräteserie in unterschiedlichen Varianten am Markt positioniert werden, ohne dass für jede Variante ein neues Platinenlayout entwickelt werden muss.

In einer Weiterentwicklung dieses Standes der Technik kann das Verbindungselement eine Mehrzahl strukturierter Kupferschichten aufweisen, welche jeweils durch eine zugeordnete Isolationsschicht, beispielsweise aus Polyimid, voneinander getrennt sind. Auf diese Weise können Leiterbahnen auf unterschiedlichen Ebenen geführt und dadurch ohne elektrischen Kontakt überkreuzt werden. Auf diese Weise kann eine Vielzahl von Signalleitungen auf kleinren Raum angeordnet werden. Darüber hinaus kann eine Kupferebene zur Abschirmung verwendet werden, wodurch sich die elektromagnetische Verträglichkeit des Verbindungselementes erhöht. Nachteilig an diesem Stand der Technik ist jedoch, dass eine Lötverbindung des Verbindungselementes auf der Platine nur mit erhöhtem Aufwand realisiert werden kann. Beispielsweise erfordert das Herstellen einer Lötverbindung zwischen einem solchen Verbindungselement und der Platine eine hohe Löttemperatur und eine vergleichsweise lange Einwirkdauer der Wärmequelle, um eine ausreichende Erwärmung der unter einer Mehrzahl von Kupferschichten und Isolationsschichten verdeckten Lötstelle sicherzustellen. Weiterhin müssen Schutzmaßnahmen ergriffen werden, damit die beim Lötvorgang verwendete Termode nicht mit dem Klebstoff des mehrlagigen Verbindungselementes in Berührung kommt.

Ausgehend von diesem Stand der Technik liegt der Erfindung die Aufgabe zugrunde, ein Verbindungselement bereitzustellen, welches in einfacher Weise mit den Anschlusskontakten einer Platine verbindbar ist und dennoch eine Vielzahl von Leiterbahnen auf begrenztem Raum und/oder eine Abschirmung bereitstellen kann.

Die Aufgabe wird erfindungsgemäß gelöst durch eine Flachbaugruppe, welche folgende Elemente enthält: Eine Platine, aus einem dielektrischen Material, auf welchem Leiterbahnen und erste Anschlusskontakte angeordnet sind, zumindest ein Bauelement mit einer Mehrzahl von zweiten Anschlusskontakten und ein Verbindungselement aus einem flexiblen Material, welches die ersten Anschlusskontakte mit den zweiten Anschlusskontakten verbindet, wobei das Verbindungselement zumindest einen ersten Längsabschnitt aufweist, in welchem Leiterbahnen und Anschlusskontakte in genau einer Ebene angeordnet sind, und zumindest einen zweiten Längsabschnitt aufweist, in welchem Leiterbahnen und/oder Anschlusskontakte in zumindest zwei Ebenen angeordnet sind, wobei eine Fügestelle zwischen dem ersten und dem zweiten Längsabschnitt vorgesehen ist.

Weiterhin besteht die Lösung der Aufgabe in einem Verfahren zur elektrischen Kontaktierung eines Bauelementes mit zweiten Anschlusskontakten auf einer Platine mit ersten Anschlusskontakten, bei welchem ein Verbindungselement aus einem flexiblen Material eingesetzt wird, welches die ersten Anschlusskontakte mit den zweiten Anschlusskontakten leitfähig verbindet, wobei das Verbindungselement zumindest einen ersten Längsabschnitt aufweist, in welchem Leiterbahnen und/oder Anschlusskontakte in genau einer Ebene angeordnet sind, und zumindest einen zweiten Längsabschnitt aufweist, in welchem Leiterbahnen und/oder Anschlusskontakte in zumindest zwei Ebenen angeordnet sind und eine Fügestelle zwischen dem ersten und dem zweiten Längsabschnitt vorgesehen ist, wobei Anschlusskontakte des zweiten Längsabschnittes mit den zweiten Kontakten des Bauelementes verbunden werden und Anschlusskontakte des ersten Längsabschnittes mit den ersten Kontakten der Platine verbunden werden.

Erfindungsgemäß wird vorgeschlagen, ein Verbindungselement zur Verbindung der Anschlusskontakte eines Bauelementes mit den zugeordneten Anschlusskontakten einer Platine einzusetzen, welches aus zwei Längsabschnitten besteht. Im ersten Längsabschnitt weist das Verbindungselement Leiterbahnen in zumindest zwei Ebenen auf. Beispielsweise können die Leiterbahnen aus einer Mehrzahl von strukturierten Metalllagen bestehen, welche jeweils vollflächig festhaftend mit zumindest einer Isolationsschicht verbunden sind. Beispielsweise kann für die Metallisierung Kupfer verwendet werden, welches mit einer Schichtdicke von etwa 10 µm bis etwa 500 µm auf einer Polyimid-Folie aufgebracht ist. Die Polyimid-Folie kann dabei insbesondere eine Dicke von etwa 25 µm bis etwa 500 µm, bevorzugt 50 µm bis 150 µm aufweisen. Die Verbindung einer Mehrzahl von Kupferschichten mit einer Mehrzahl von Isolationsschichten kann beispielsweise durch Aufdampfen, Sputtern oder Kleben erfolgen. Auf diese Weise wird der zweite Längsabschnitt des Verbindungselementes von einer mehrlagigen, flexiblen gedruckten Leiterplatte gebildet. Dieser Längsabschnitt des Verbindungselementes eignet sich insbesondere dazu, eine Vielzahl von Verbindungsleitungen auf engem Raum zu führen und falls notwendig, auch durch Überkreuzen auf unterschiedlichen Ebenen zu vertauschen.

Erfindungsgemäß wurde erkannt, dass das Verbindungselement in einfacher Weise auf den Anschlusskontakten einer Platine verlötet werden kann, wenn eine Fügestelle vorgesehen wird, an welcher das mehrlagige Verbindungselement in ein einlagiges Verbindungselement übergeht, welches lediglich eine einzelne Metallisierungsebene aufweist, welche in an sich bekannter Weise strukturiert ist, um eine Mehrzahl von Leiterbahnen auszubilden. Die Fügestelle zwischen dem ersten Längsabschnitt des Verbindungselementes und dem zweiten Längsabschnitt des Verbindungselementes kann beispielsweise durch eine Lötverbindung hergestellt werden. Da in diesem Fall die für den Lötprozess erforderliche thermische Energie durch den ersten Längsabschnitt hindurch eingebracht werden kann, vermeidet die Erfindung in besonders vorteilhafte Weise, die thermische Energie des Lötprozesses durch mehrere Metallisierungsebenen und mehrere Isolationslagen hindurch an die Fügestelle bringen zu müssen.

In einer bevorzugten Weiterbildung der Erfindung umfasst die Fügestelle zwischen dem ersten und dem zweiten Längsabschnitts des Verbindungselementes eine Klebeverbindung mittels eines anisotrop leitfähigen Films. Ein solcher anisotrop leitfähiger Film kann beispielsweise ein thermoplastisches Material umfassen, in welchem leitfähige Teilchen dispergiert sind. Die Kontaktstellen des ersten Längsabschnittes und des zweiten Längsabschnittes können unter Druck- und/oder Temperatureinwirkung auf die gegenüberliegenden Seiten des Films gepresst werden, so dass sich das Basismaterial des Films verformt und die in diesem verteilten leitfähigen Teilchen eine elektrisch leitende Verbindung zwischen den aufgebrachten Leiterbahnen herstellen. Auf diese Weise kann die Fügestelle zwischen dem ersten und dem zweiten Längsabschnitt des Verbindungselementes bei niedriger Temperatur hergestellt werden, wodurch eine Schädigung des Verbindungselementes an der Fügestelle ausgeschlossen wird.

In gleicher Weise kann das Verbindungselement besonders einfach mit dem ersten Längsabschnitt auf den Anschlusskontakten einer Platine verlötet werden, da auch in diesem Fall die für den Lötprozess erforderliche thermische Energie durch den ersten Längsabschnitt mit nur einer Metallisierungsebene und einer Isolationsebene eingebracht werden kann. Der aufwändige Lötprozess eines mehrlagigen Verbindungselementes mit mehreren Metallisierungsebenen und mehreren Isolationslagen wird vermieden. Dadurch wird die Zuverlässigkeit und die Verarbeitungsgeschwindigkeit des Bestückungsprozesses der Platine verbessert.

In einer bevorzugten Weiterbildung der Erfindung kann auf dem zweiten Längsabschnitt des Verbindungselementes zumindest ein weiteres elektronisches Bauelement angeordnet sein. Auf diese Weise kann Bauraum auf der Platine eingespart werden. Weiterhin können die Leitungsverbindungen zwischen dem mittels des Verbindungselementes kontaktierten Bauelement und den weiteren Bauelementen auf dem zweiten Längsabschnitt des Verbindungselementes kurz gehalten werden, was insbesondere bei hochfrequenten Signalen eine geringere Dämpfung und eine bessere Signalqualität bewirkt. Das weitere elektronische Bauelement kann beispielsweise ein Displaycontroller sein, welcher ein komplexes Ansteuersignal von der Platine in Adress- und Helligkeitsdaten einzelner Pixel umsetzt.

Nachfolgend soll die Erfindung anhand eines Ausführungsbeispiels und zweier Figuren ohne Beschränkung des allgemeinen Erfindungsgedankens näher erläutert werden. Dabei zeigt
Fig. 1 den schematischen Aufbau der Verbindung zwischen einem Bauelement und einer Leiterplatte mittels des erfindungsgemäßen Verbindungselementes.
Fig. 2 zeigt die Montage eines Displays auf einer Platine.

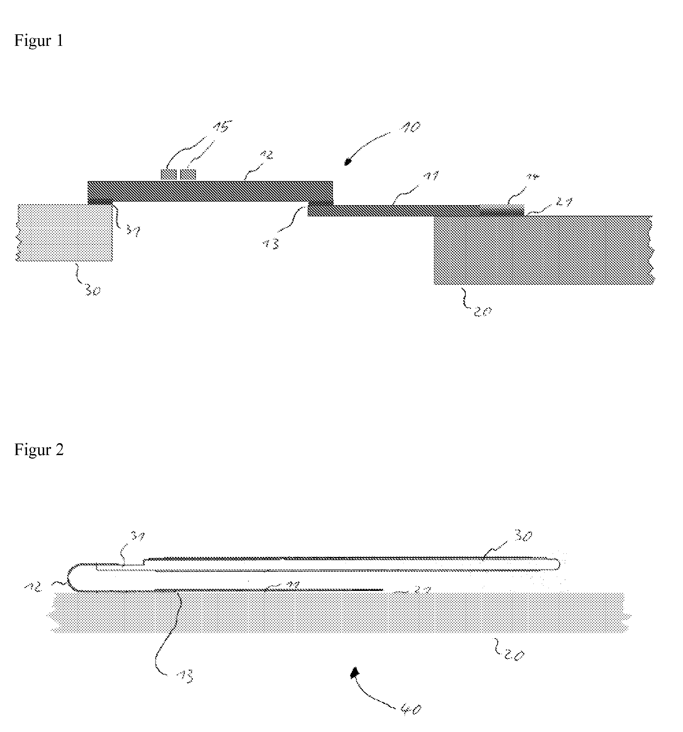

Fig. 1 zeigt den Querschnitt durch einen Ausschnitt aus einer Platine 20. Die Platine 20 besteht aus einem isolierenden Material, auf welchem Leiterbahnen angeordnet sind. Ein isolierendes Material kann erfindungsgemäß insbesondere auch ein Dielektrikum sein. Dabei können die Leiterbahnen auf der Platine 20 einseitig oder mehrseitig angeordnet sein. Weiterhin kann vorgesehen sein, dass die Platine 20 in ihrem Inneren weitere Metallisierungslagen birgt, welche ebenfalls in Form von Leiterbahnen strukturiert sein können. Über entsprechende Durchführungen können Leiterbahnen über verschiedene Leiterbahnebenen hinweg verlegt werden.

An ihrer Oberseite weist die Platine 20 einen Anschlussbereich auf, in welchem Anschlusskontakte 21 angeordnet sind. Beispielsweise kann die Anzahl der Anschlusskontakte 21 zwischen 2 und 100 betragen. In einer bevorzugten Ausführungsform beträgt die Anzahl der Anschlusskontakte 21 etwa 10 bis etwa 50.

Die Anschlusskontakte 21 sind dazu vorgesehen, elektrische Signale von einem Bauelement 30 entgegenzunehmen beziehungsweise solche Signale dem Bauelement 30 zuzuführen. Das Bauelement 30 weist hierzu ebenfalls eine Mehrzahl von Anschlusskontakten 31 auf. Das Bauelement 30 kann beispielsweise ein Mikroprozessor, ein Speicherbaustein, ein LCD-Display oder ein beliebiger anderer integrierter Schaltkreis sein.

Das Verbindungselement 10 ist dazu vorgesehen, die Anschlusskontakte 31 des Bauelementes 30 mit ihren jeweiligen zugeordneten Anschlusskontakten 21 der Platine 20 elektrisch leitfähig zu verbinden. Hierzu weist das Verbindungselement 10 einen ersten Längsabschnitt 11 auf, in welchem Leiterbahnen und Anschlusskontakte in genau einer Ebene angeordnet sind. Der erste Längsabschnitt 11 des Verbindungselementes 10 besteht somit im Wesentlichen aus einer isolierenden Materiallage, welche einseitig mit einer Metallisierung versehen ist. Die Metallisierung kann in an sich bekannter Weise durch Belichten und Ätzen strukturiert werden, um eine Mehrzahl von Anschlusskontakten und Leiterbahnen auszubilden. Als isolierende Materiallage eignet sich insbesondere ein Polymer, besonders bevorzugt Polyimid. Die Metallisierung umfasst insbesondere Kupfer oder eine Kupferlegierung. Die Metallisierung kann mehrere Schichten verschiedener Metalle oder Legierungen umfassen, welche übereinander angeordnet sind. Die nicht von Anschlusskontakten belegten Flächenbereiche können zumindest teilweise mit einer weiteren isolierenden Materiallage bedeckt sein, um Kurzschlüsse zu vermeiden.

Die Anschlusskontakte 21 können beispielsweise durch einen Lötvorgang mit den zugeordneten Anschlusskontakten des ersten Längsabschnittes des Verbindungselementes 10 verbunden werden. Hierzu eignet sich insbesondere ein Termodenlötverfahren. In diesem Fall kann der erste Längsabschnitt 11 eine optionale Kontaktfläche 14 aufweisen, welche dazu eingerichtet ist, die Termode beim Lötvorgang aufzunehmen, ohne die übrigen Flächenbereiche des ersten Längsabschnitts 11 des Verbindungsabschnittes 10 zu beschädigen. Die Kontaktfläche kann dazu eingerichtet sein, eine verbesserte Wärmeübertragung von der Termode zu den Lötstellen zu ermöglichen.

Das den Anschlusskontakten 21 gegenüberliegende Ende des ersten Längsabschnittes 11 weist weitere Anschlusskontakte auf, welche dazu vorgesehen sind, über eine elektrisch leitfähige Fügestelle 13 mit zugeordneten Anschlusskontakten am ersten Ende des zweiten Längsabschnittes 12 des Verbindungselementes 10 verbunden zu werden. Auch die Fügestelle 13 kann beispielsweise in einem Termodenlötverfahren hergestellt werden, wobei bevorzugt die Termode auf der Oberfläche des ersten Längsabschnittes 11 aufgesetzt wird.

Bevorzugt wird die Fügestelle 13 mittels eines leitfähigen Klebstoffes hergestellt, besonders bevorzugt mit einem anisotrop leitfähigen Klebstoff. Solche Klebstoffe umfassen beispielsweise ein Trägermaterial aus einem Kunstharz oder einem Thermoplast, welches mit leitfähigen Partikeln gefüllt ist. Die Partikel enthalten beispielsweise ein Metall, eine Legierung oder Kohlenstoff.

Im zweiten Längsabschnitt 12 des Verbindungselementes 10 sind Leiterbahnen und/oder Anschlusskontakte in zumindest zwei Ebenen angeordnet. Dies bedeutet, dass der zweite Längsabschnitt 12 zumindest eine isolierende Materiallage umfasst, auf welcher beidseitig eine Metallisierung angeordnet ist. Eine oder mehrere Metallisierungen können mittels eines an sich bekannten Belichtungs- und Ätzprozesses strukturiert werden, um Leiterbahnen, Anschlusskontakte, Testpunkte oder Abschirmungen auszubilden. Fallweise kann der zweite Längsabschnitt 12 des Verbindungselementes 10 auch aus einer Mehrzahl von isolierenden Materiallagen mit jeweils einer Mehrzahl dazwischen angeordneter, strukturierter Metallisierungsebenen aufgebaut sein. Auf diese Weise ergeben sich mehr als zwei Ebenen, in welchen Leiterbahnen und/oder Anschlusskontakte angeordnet sind. Mittels leitfähig gefüllter Bohrungen können einzelne Leiterbahnen auch über verschiedene Ebenen geführt werden. Auf diese Weise verbindet der zweite Längsabschnitt die Anschlusskontakte an der Fügestelle 13 mit zugeordneten Anschlusskontakten 31 des Bauelementes 30. Dabei kann die Verbindung zweier Anschlusskontakte zwischen dem ersten und dem zweiten Ende des zweiten Längsabschnittes 12 direkt verlaufen, d. h. ohne weitere, dazwischen liegende Bauelemente.

Weiterhin kann vorgesehen sein, dass die Verbindung zweier Anschlusskontakte zwischen dem ersten und dem zweiten Ende des zweiten Längsabschnittes 12 über zumindest ein weiteres Bauelement 15 verläuft. Das weitere Bauelement 15 kann insbesondere einen Controller umfassen, welcher Eingangssignale von Bauelementen auf der Platine 20 entgegennimmt und diese in Ausgangssignale umsetzt, welche zur Ansteuerung des Bauelementes 30 dienen. Sofern das Bauelement 30 ein LCD-Display ist, kann das weitere Bauelement 15 ein Displaycontroller sein. Selbstverständlich kann das weitere Bauelement 15 auch jedes andere bekannte, aktive oder passive Bauelement sein. Bevorzugt, aber nicht zwingend, weist das weitere Bauelement 15 ein SMD-Gehäuse auf. Das weitere weitere Bauelement 15 wird in an sich bekannter Weise auf dem zweiten Längsabschnitt 12 des Verbindungselementes 10 befestigt, beispielsweise durch Reflow-Löten.

Die Anschlusskontakte 31 des Bauelementes 30 sind mit zugeordneten Anschlusskontakten des zweiten Längsabschnittes 12 leitfähig und mechanisch belastbar verbunden, beispielsweise durch einen Lötprozess, eine Klemmverbindung oder mittels eines leitfähigen Klebstoffes, wie im Zusammenhang mit der Fügestelle 13 erläutert.

Die Erfindung vereint die Möglichkeit der einfachen Kontaktierung des ersten Längsabschnittes 11 auf den Kontakten 21 der Platine 20 mit der hohen Flexibilität bezüglich des Schaltungslayouts und der Anordnung weiterer Bauelemente 15 auf dem zweiten Längsabschnitt 12, in welchem Leiterbahnen und Anschlusskontakte in zumindest zwei Ebenen angeordnet sind.

Fig. 2 zeigt nochmals einen Querschnitt durch eine erfindungsgemäße Flachbaugruppe 40. Die Flachbaugruppe 40 kann beispielsweise Bestandteil eines Telekommunikationsendgerätes sein. Die Flachbaugruppe 40 umfasst eine Platine 20 mit zugeordneten Anschlusskontakten 21, wie im Hinblick auf Fig. 1 erläutert. Auf der Platine 20 ist ein Bauelement 30 angeordnet. Das Bauelement 30 ist im dargestellten Ausführungsbeispiel ein LCD-Display. Das Display 30 kann beispielsweise ein TFT-Display sein, bei welchen eine Mehrzahl elektrisch leitfähiger Siliziumschichten auf einem Glassubstrat angeordnet und strukturiert wird, um einzelne Pixel des LCD-Displays über eine Zeilen- und eine Spaltenadresse zu adressieren und dadurch ein- oder auszuschalten. Das Bauelement 30 kann eine im Wesentlichen rechteckige Grundform haben. An einer Kante des Bauelementes 30 befindet sich eine Mehrzahl von Anschlusskontakten 31, welche beispielsweise in einem gleichmäßigen Raster angeordnet sind. Beispielsweise können die Anschlusskontakte 31 die Zeilen und Spalten des LCD-Displays ansteuern, um ein Pixel des LCD-Displays zu schalten.

Zur elektrischen Verbindung der Anschlusskontakte 31 des Bauelementes 30 mit den Anschlusskontakten 21 der Platine 20 steht ein erfindungsgemäßes Verbindungselement 10 zur Verfügung. Das Verbindungselement 10 ist mit seinem zweiten Längsabschnitt 12 mit den Anschlusskontakten 31 kontaktiert, beispielsweise durch eine Lötverbindung oder eine Klebeverbindung. Weiterhin weist das Verbindungselement 10 einen weiteren Längsabschnitt 11 auf, welcher mit dem zweiten Längsabschnitt 12 mittels einer Fügestelle 13 verbunden ist. Das Bauelement 30 kann bereits bei seiner Herstellung mit dem Verbindungselement 10 versehen werden.

Bei der Herstellung der Flachbaugruppe 40 wird dann nur noch das freie Ende des ersten Längsabschnittes 11 mit den Anschlusskontakten 21 der Platine 20 verlötet. Da der erste Längsabschnitt 11 Leiterbahnen und Anschlusskontakte nur in genau einer Ebene aufweist, kann diese Lötverbindung mit den Anschlusskontakten 21 in an sich bekannter Weise besonders schnell und zuverlässig hergestellt werden. Nachdem die Lötverbindung an den ersten Anschlusskontakten 21 fertig gestellt wurde, erlaubt das flexible Verbindungselement 10 das Abklappen des Bauelementes 30 in die in Fig. 2 dargestellte endgültige Einbaulage.

Sofern die Flachbaugruppe 40 mit unterschiedlichen Bauelementen 30, beispielsweise mit unterschiedlichen Displaymodulen, bestückt werden soll, welche unterschiedliche Anschlusskontakte 31 aufweisen, kann durch Anpassen des ersten Längsabschnittes 11 und/oder des zweiten Längsabschnittes 12 des Verbindungselementes 10 eine weitergehende Änderung der Platine 20 der Flachbaugruppe 40 vermieden werden.

Dem Fachmann ist selbstverständlich geläufig, dass die Erfindung nicht auf die dargestellten Ausführungsbeispiele beschränkt ist. Vielmehr können durch Modifikationen und Änderungen weitere Ausführungsbeispiele erhalten werden, ohne die Erfindung an sich wesentlich zu verändern.

## Patentansprüche

1. Flachbaugruppe (40), welche folgende Elemente enthält:
• eine Platine (20) aus einem dielektrischen Material, auf welchem Leiterbahnen und erste Anschlusskontakte (21) angeordnet sind,
• zumindest ein Bauelement (30) mit einer Mehrzahl von zweiten Anschlusskontakten (31),
• ein Verbindungselement (10) aus einem flexiblen Material, welches die ersten Anschlusskontakte (21) mit den zweiten Anschlusskontakten (31) verbindet, wobei das Verbindungselement (10) zumindest einen ersten Längsabschnitt (11) aufweist, in welchem Leiterbahnen und Anschlusskontakte in genau einer Ebene angeordnet sind, und zumindest einen zweiten Längsabschnitt (12) aufweist, in welchem Leiterbahnen und/oder Anschlusskontakte in zumindest zwei Ebenen angeordnet sind, wobei eine Fügestelle (13) zwischen dem ersten und dem zweiten Längsabschnitt (11, 12) vorgesehen ist.

2. Flachbaugruppe (40) nach Anspruch 1, **dadurch gekennzeichnet, dass** der zweite Längsabschnitt (12) des Verbindungselementes (10) weitere elektronische Bauelemente enthält.

3. Flachbaugruppe (40) nach Anspruch 1 oder 2, **dadurch gekennzeichnet, dass** die Fügestelle (13) zwischen dem ersten und dem zweiten Längsabschnitt (11, 12) des Verbindungselementes (10) eine Lötverbindung und/oder eine Klebeverbindung enthält.

4. Flachbaugruppe (40) nach Anspruch 3, **dadurch gekennzeichnet, dass** die Klebeverbindung mittels eines anisotrop leitfähigen Klebstoffes erhältlich ist.

5. Flachbaugruppe (40) nach einem der Ansprüche 1 bis 4, **dadurch gekennzeichnet, dass** die Fügestelle (13) zwischen dem ersten Längsabschnitt (11) des Verbindungselementes (10) und den ersten Anschlusskontakten (21) mittels einer Lötverbindung hergestellt ist.

6. Flachbaugruppe (40) nach einem der Ansprüche 1 bis 5, **dadurch gekennzeichnet, dass** das Bauelement (30) ein Display ist.

7. Flachbaugruppe (40) nach einem der Ansprüche 1 bis 6, **dadurch gekennzeichnet, dass** auf dem zweiten Längsabschnitt (12) des Verbindungselementes (10) weitere elektronische Bauelemente (15) angeordnet sind.

8. Telekommunikationsendgerät mit einer Flachbaugruppe (40) nach einem der Ansprüche 1 bis 7.

9. Verfahren zur elektrischen Kontaktierung eines Bauelementes (30) mit zweiten Anschlusskontakten (31) auf einer Platine (20) mit ersten Anschlusskontakten (21), bei welchem ein Verbindungselement (10) aus einem flexiblen Material eingesetzt wird, welches die ersten Anschlusskontakte (21) mit den zweiten Anschlusskontakten (31) leitfähig verbindet, **dadurch gekennzeichnet, dass** das Verbindungselement (10) zumindest einen ersten Längsabschnitt (11) aufweist, in welchem Leiterbahnen und/oder Anschlusskontakte in genau einer Ebene angeordnet sind, und zumindest einen zweiten Längsabschnitt (12) aufweist, in welchem Leiterbahnen und/oder Anschlusskontakte in zumindest zwei Ebenen angeordnet sind und eine Fügestelle (13) zwischen dem ersten und dem zweiten Längsabschnitt (11, 12) vorgesehen ist, wobei Anschlusskontakte des zweiten Längsabschnittes (12) mit den zweiten Kontakten (31) des Bauelementes (30) verbunden werden und Anschlusskontakte des ersten Längsabschnittes (11) mit den ersten Kontakten (21) der Platine (20) verbunden werden.

10. Verfahren nach Anspruch 9, **dadurch gekennzeichnet, dass** die Anschlusskontakte des ersten Längsabschnittes (11) mit den ersten Kontakten (21) der Platine (20) mittels einer Lötverbindung verbunden werden, insbesondere mittels einer mit dem Termodenlötverfahren hergestellten Lötverbindung.

11. Verfahren nach einem der Ansprüche 9 oder 10, **dadurch gekennzeichnet, dass** die Fügestelle (13) zwischen dem ersten und dem zweiten Längsabschnitt (11, 12) des Verbindungselementes (10) mittels Kleben und/oder Löten hergestellt wird.

12. Verfahren nach Anspruch 11, **dadurch gekennzeichnet, dass** die Klebeverbindung mittels eines anisotrop leitfähigen Klebstoffes hergestellt wird.

13. Verfahren nach einem der Ansprüche 9 bis 12, **dadurch gekennzeichnet, dass** auf dem zweiten Längsabschnitt (12) des Verbindungselementes (10) weitere elektronische Bauelemente (15) angeordnet werden.
